# EUROPEAN PATENT APPLICATION

(11) **EP 4 456 692 A1**
(43) Date of publication of application: **30.10.2024**
(21) Application number: 23219687.3
(22) Date of filing: 22.12.2023
(51) Int. Cl.: H10B 10/00, H01L 27/02, H01L 27/06, H01L 27/092

(54) **SEMICONDUCTOR MEMORY DEVICE AND METHOD OF FABRICATING THE SAME**

(30) Priority: 28.04.2023 KR 20230056019
(71) Applicant: Samsung Electronics Co., Ltd., Suwon-si, Gyeonggi-do 16677 (KR)
(72) Inventor: KIM, Jeewoong, 16677 Suwon-si (KR); CHO, Kyung Hee, 16677 Suwon-si (KR)
(74) Representative: Marks & Clerk LLP

(57) **Abstract**

A semiconductor memory device includes a substrate including a first surface and a second surface, which are opposite to each other, a lower active region on the first surface, the lower active region including a lower gate electrode and a lower active contact, which are spaced apart from each other, an upper active region stacked on the lower active region, the upper active region including an upper gate electrode and an upper active contact, which are spaced apart from each other, a first metal layer on the first surface, and a back-side metal layer on the second surface. The back-side metal layer includes a first shared pad electrically connecting the lower gate electrode to the lower active contact. The first metal layer includes a second shared pad electrically connecting the upper gate electrode to the upper active contact.

## Description

### TECHINCAL FIELD

The present disclosure relates to a semiconductor memory device and a method of fabricating the same, and in particular, to a semiconductor memory device including a static random access memory (SRAM) cell and a method of fabricating the same.

### BACKGROUND

Due to their small-sized, multifunctional, and/or low-cost characteristics, semiconductor devices are being esteemed as important elements in the electronics industry. The semiconductor devices are classified into a semiconductor memory device for storing data, a semiconductor logic device for processing data, and a hybrid semiconductor device including both of memory and logic elements. As the electronic industry advances, there is an increasing demand for semiconductor devices with improved characteristics. For example, there is an increasing demand for semiconductor devices with high reliability, high performance, and/or multiple functions. To meet this demand, structural complexity and/or integration density of semiconductor devices are being increased.

### SUMMARY

An embodiment of the inventive concept provides a semiconductor memory device with improved electrical characteristics and an increased integration density.

An embodiment of the inventive concept provides a method of fabricating a semiconductor memory device with improved electrical characteristics and an increased integration density.

According to an embodiment of the inventive concept, a semiconductor memory device may include a substrate including a first surface and a second surface, which are opposite to each other, a lower active region on the first surface, the lower active region including a lower gate electrode and a lower active contact, which are spaced apart from each other, an upper active region stacked on the lower active region, the upper active region including an upper gate electrode and an upper active contact, which are spaced apart from each other, a first metal layer on the first surface, and a back-side metal layer on the second surface. The back-side metal layer may include a first shared pad electrically connecting the lower gate electrode to the lower active contact. The first metal layer may include a second shared pad electrically connecting the upper gate electrode to the upper active contact.

According to an embodiment of the inventive concept, a semiconductor memory device may include an SRAM cell on a substrate. The SRAM cell may include a back-side metal layer, a lower active region on the back-side metal layer, an upper active region on the lower active region, and a first metal layer on the upper active region. The lower active region may include four p-channel metal-oxide-semiconductor field-effect transistors (PMOSFETs), which are arranged in the form of 2 X 2 array, and the upper active region may include four n-channel metal-oxide-semiconductor field-effect transistors (NMOSFETs), which are arranged in the form of 2 X 2 array. The lower active region may include a first pull-up transistor and a second pull-up transistor, and the upper active region may include a first pull-down transistor and a second pull-down transistor. The first pull-down transistor may be stacked on the first pull-up transistor, and the second pull-down transistor may be stacked on the second pull-up transistor.

According to an embodiment of the inventive concept, a semiconductor memory device may include a substrate including a first surface and a second surface, which are opposite to each other, a lower active region on the first surface, the lower active region including a lower channel pattern and a lower source/drain pattern, an upper active region stacked on the lower active region, the upper active region including an upper channel pattern and an upper source/drain pattern, a lower gate electrode on the lower channel pattern, an upper gate electrode on the upper channel pattern, an interlayer insulating layer on the upper gate electrode and the upper source/drain pattern, a lower active contact provided to penetrate the substrate and electrically connected to the lower source/drain pattern, an upper active contact provided to penetrate the interlayer insulating layer and electrically connected to the upper source/drain pattern, a back-side metal layer on the second surface of the substrate, a lower via electrically connecting the back-side metal layer to the lower active contact, a first metal layer on the interlayer insulating layer, an upper via electrically connecting the first metal layer to the upper active contact, and a cutting structure provided to penetrate the lower gate electrode, the lower active contact, the upper gate electrode, and the upper active contact.

At least some of the above and other features of the invention are set out in the claims.

### BRIEF DESCRIPTION OF THE DRAWINGS

FIG. 1 is an equivalent circuit diagram illustrating a SRAM cell according to an embodiment of the inventive concept.
FIG. 2A is a plan view illustrating a first surface of a substrate in a semiconductor memory device according to an embodiment of the inventive concept.
FIG. 2B is a plan view illustrating a second surface of a substrate in a semiconductor memory device according to an embodiment of the inventive concept.
FIG. 3A is a sectional view taken along a line A-A' of FIGS. 2A and 2B.
FIG. 3B is a sectional view taken along a line B-B' of FIGS. 2A and 2B.
FIG. 3C is a sectional view taken along a line C-C' of FIGS. 2A and 2B.
FIG. 4 is a perspective view illustrating layers constituting a first bit cell according to an embodiment of the inventive concept.
FIGS. 5A to 9C are sectional views illustrating a method of fabricating a semiconductor memory device according to an embodiment of the inventive concept.

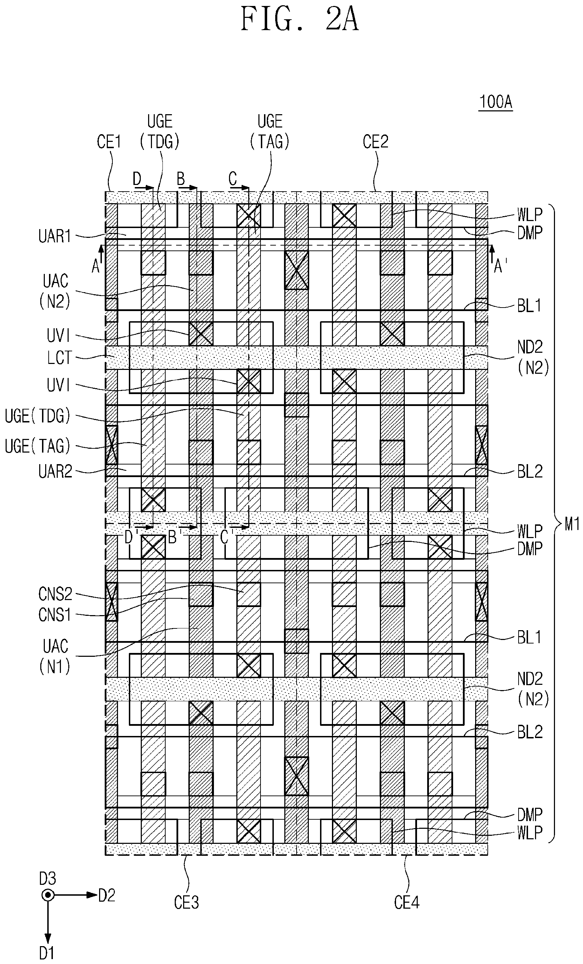

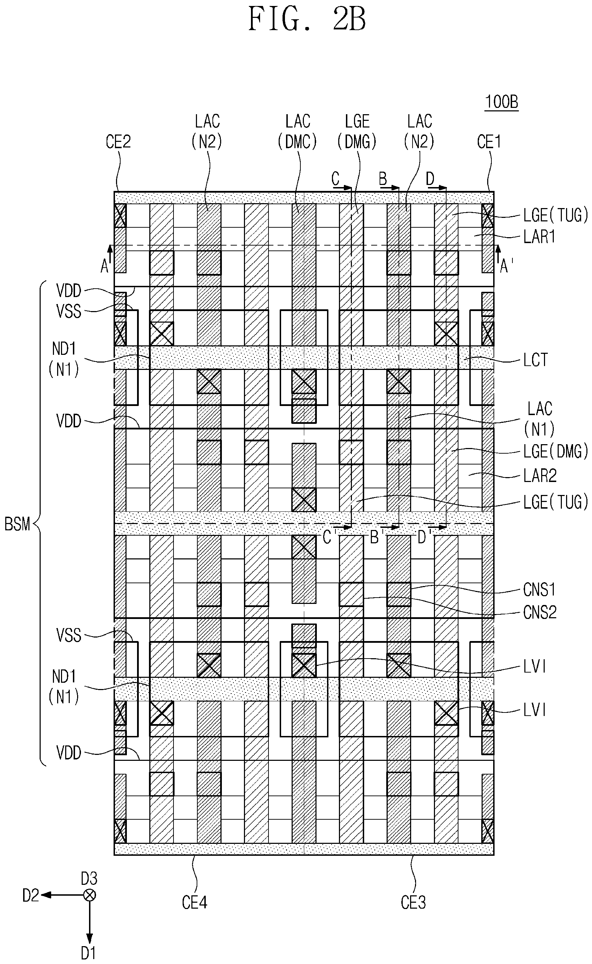

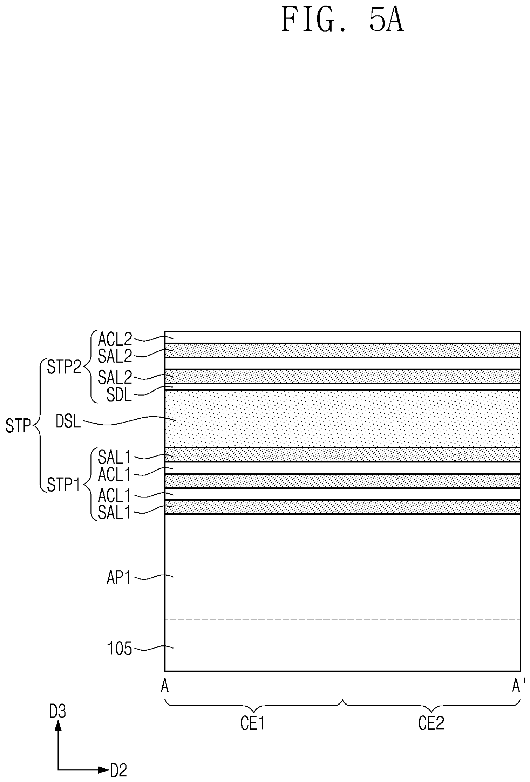

FIGS. 5A, 6A, 7A, 8A, and 9A are sectional views taken along the line A-A' of FIGS. 2A and 2B.

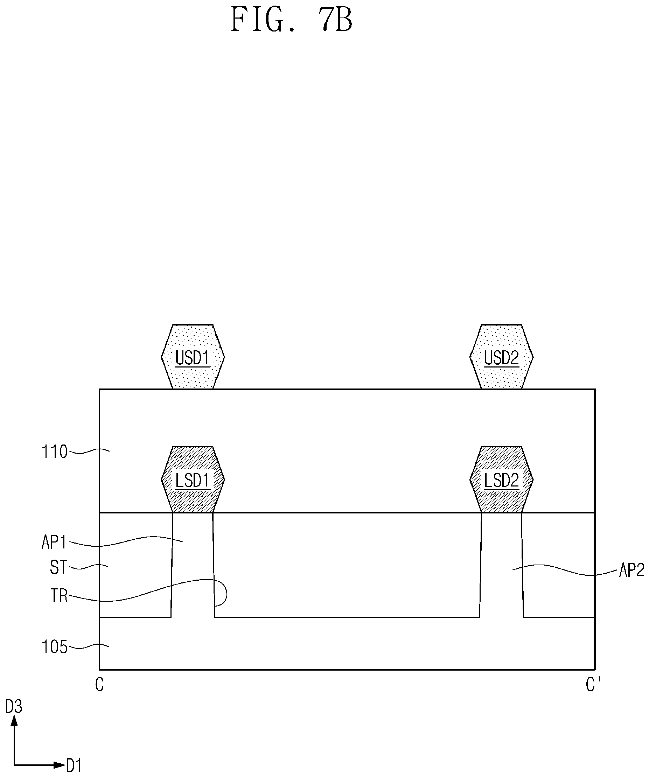

FIGS. 7B, 8B, and 9B are sectional views taken along the line B-B' of FIGS. 2A and 2B.

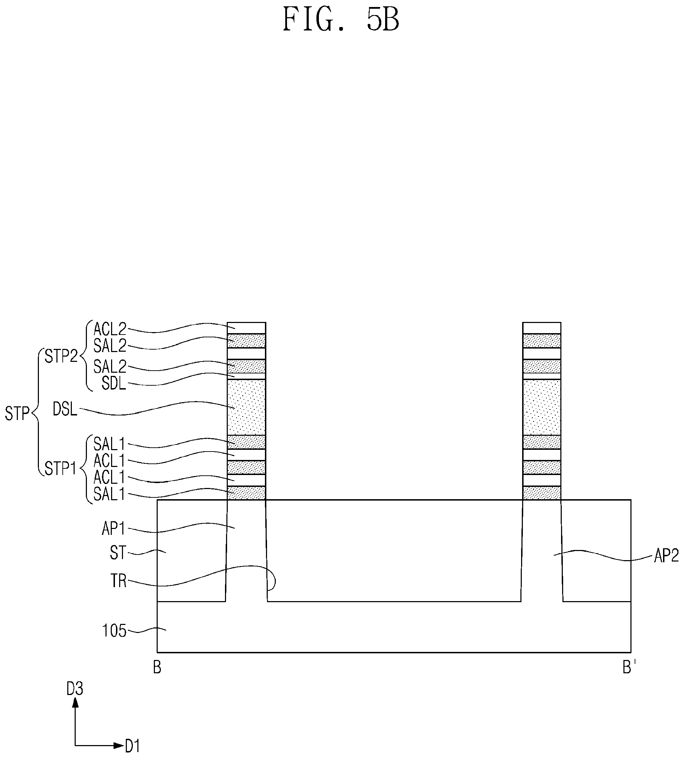

FIGS. 5B, 6B, 8C and 9C are sectional views taken along the line C-C' of FIGS. 2A and 2B.

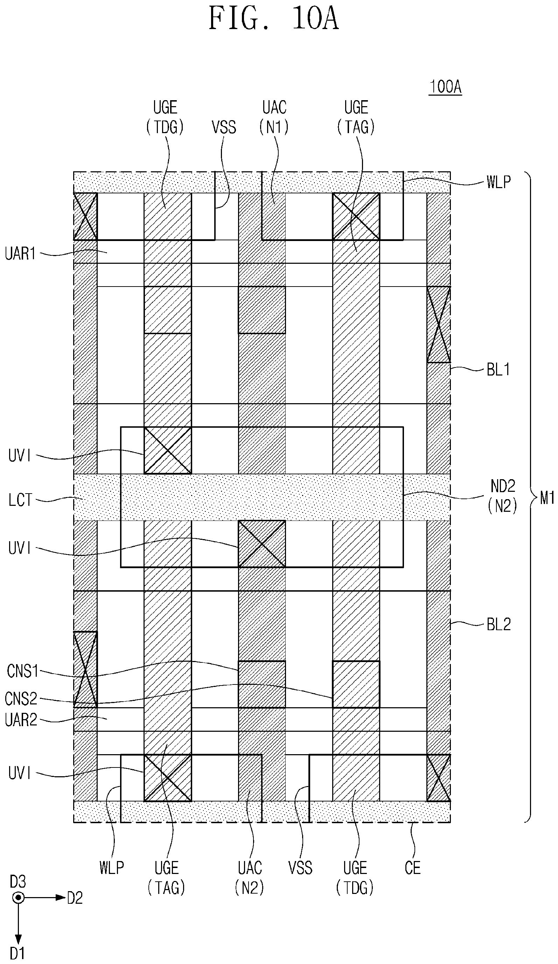

FIG. 10A is a plan view illustrating a first surface of a substrate in a semiconductor memory device according to an embodiment of the inventive concept.

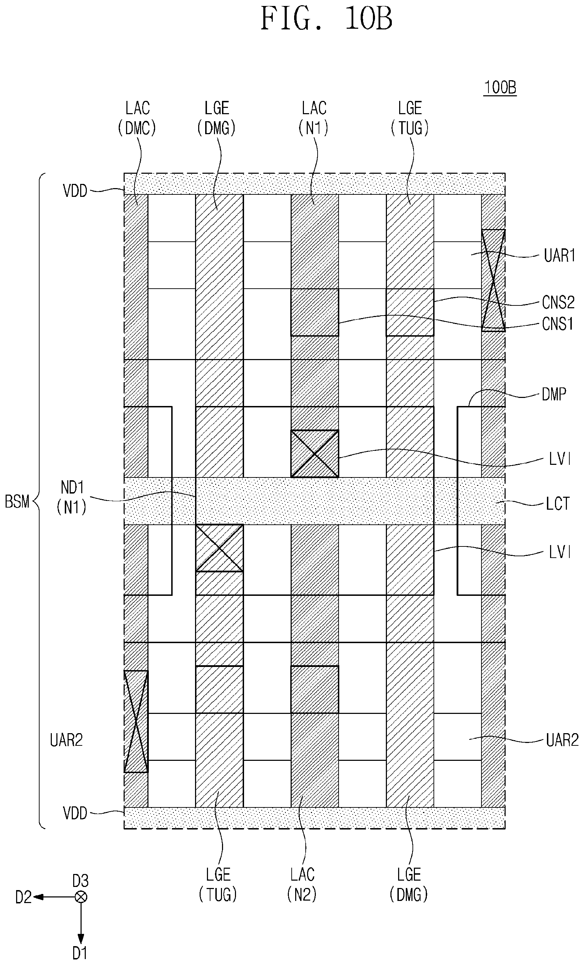

FIG. 10B is a plan view illustrating a second surface of a substrate in a semiconductor memory device according to an embodiment of the inventive concept.

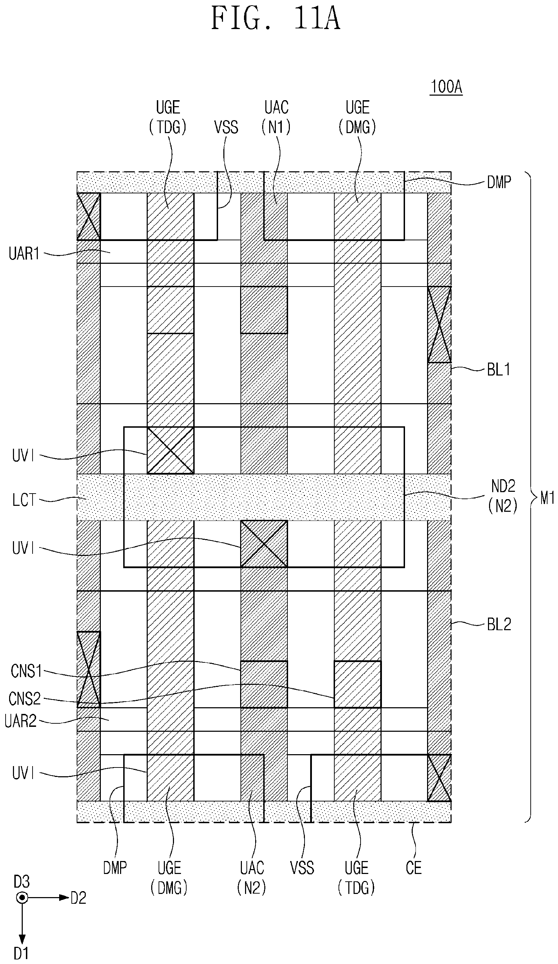

FIG. 11A is a plan view illustrating a first surface of a substrate in a semiconductor memory device according to an embodiment of the inventive concept.

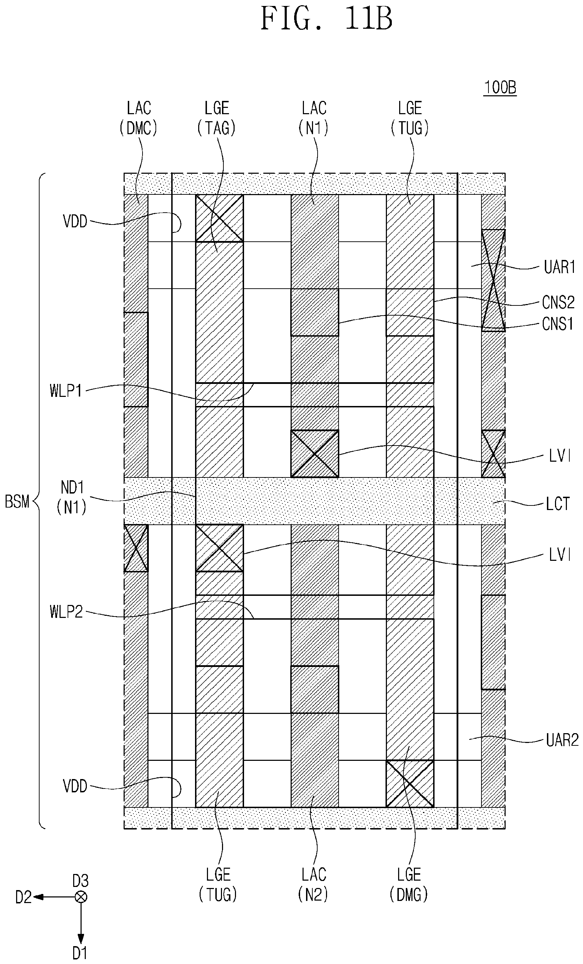

FIG. 11B is a plan view illustrating a second surface of a substrate in a semiconductor memory device according to an embodiment of the inventive concept.

### DETAILED DESCRIPTION

Example embodiments of the inventive concepts will now be described more fully with reference to the accompanying drawings, in which example embodiments are shown. In order to clearly describe the present disclosure, parts considered irrelevant to the description may be omitted for clarity, and the same or similar elements will be denoted by the same reference labels throughout the specification and the drawings.

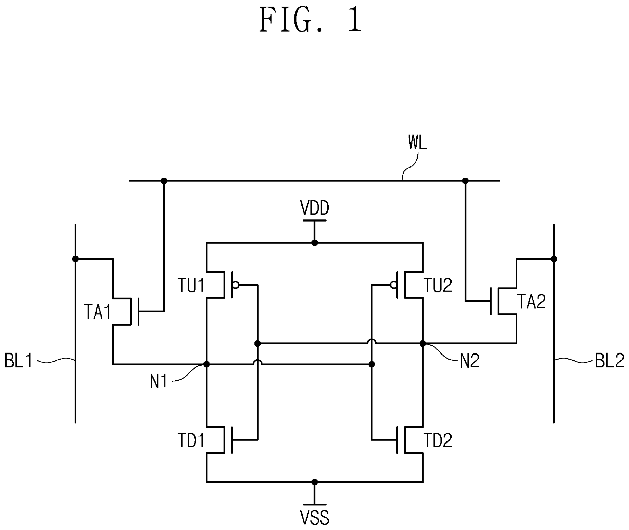

FIG. 1 is an equivalent circuit diagram illustrating an SRAM cell according to an embodiment of the inventive concept. Referring to FIG. 1, an SRAM cell according to an embodiment of the inventive concept may include a first pull-up transistor TU1, a first pull-down transistor TD1, a second pull-up transistor TU2, a second pull-down transistor TD2, a first pass-gate transistor TA1, and a second pass-gate transistor TA2. The first and second pull-up transistors TU1 and TU2 may be p-type (i.e., p-channel) metal-oxide-semiconductor (PMOS) transistors. The first and second pull-down transistors TD1 and TD2 and the first and second pass-gate transistors TA1 and TA2 may be n-type (i.e., n-channel) metal-oxide-semiconductor (NMOS) transistors.

A first source/drain of the first pull-up transistor TU1 and a first source/drain of the first pull-down transistor TD1 may be connected to a first node N1. A second source/drain of the first pull-up transistor TU1 may be connected to a power line VDD, and a second source/drain of the first pull-down transistor TD1 may be connected to a ground line VSS. A gate of the first pull-up transistor TU1 and a gate of the first pull-down transistor TD1 may be electrically connected to each other. The first pull-up transistor TU1 and the first pull-down transistor TD1 may constitute a first inverter. The connected gates of the first pull-up and first pull-down transistors TU1 and TD1 may correspond to an input terminal of the first inverter, and the first node N1 may correspond to an output terminal of the first inverter.

A first source/drain of the second pull-up transistor TU2 and a first source/drain of the second pull-down transistor TD2 may be connected to a second node N2. A second source/drain of the second pull-up transistor TU2 may be connected to the power line VDD, and a second source/drain of the second pull-down transistor TD2 may be connected to the ground line VSS. A gate of the second pull-up transistor TU2 and a gate of the second pull-down transistor TD2 may be electrically connected to each other. Thus, the second pull-up transistor TU2 and the second pull-down transistor TD2 may constitute a second inverter. The connected gates of the second pull-up and second pull-down transistors TU2 and TD2 may correspond to an input terminal of the second inverter, and the second node N2 may correspond to an output terminal of the second inverter.

The first and second inverters may be combined to form a latch structure. For example, the gates of the first pull-up and first pull-down transistors TU1 and TD1 may be electrically connected to the second node N2, and the gates of the second pull-up and second pull-down transistors TU2 and TD2 may be electrically connected to the first node N1 (i.e., arranged in a cross-coupled configuration). A first source/drain of the first pass-gate transistor TA1 may be connected to the first node N1, and a second source/drain of the first pass-gate transistor TA1 may be connected to a first bit line BL1. A first source/drain of the second pass-gate transistor TA2 may be connected to the second node N2, and a second source/drain of the second pass-gate transistor TA2 may be connected to a second bit line BL2. Gates of the first and second pass-gate transistors TA1 and TA2 may be electrically coupled to a word line WL. Thus, the SRAM cell according to an embodiment of the inventive concept may be realized.

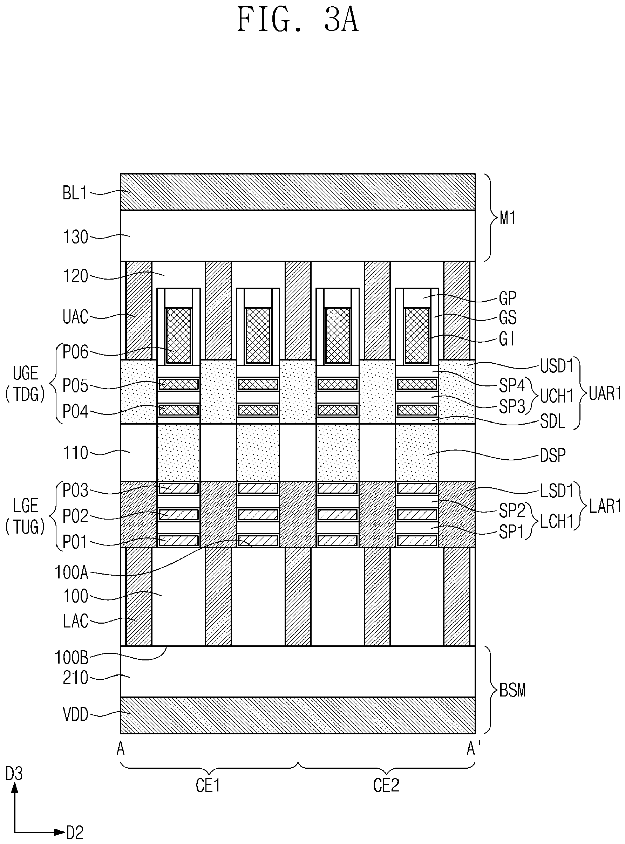

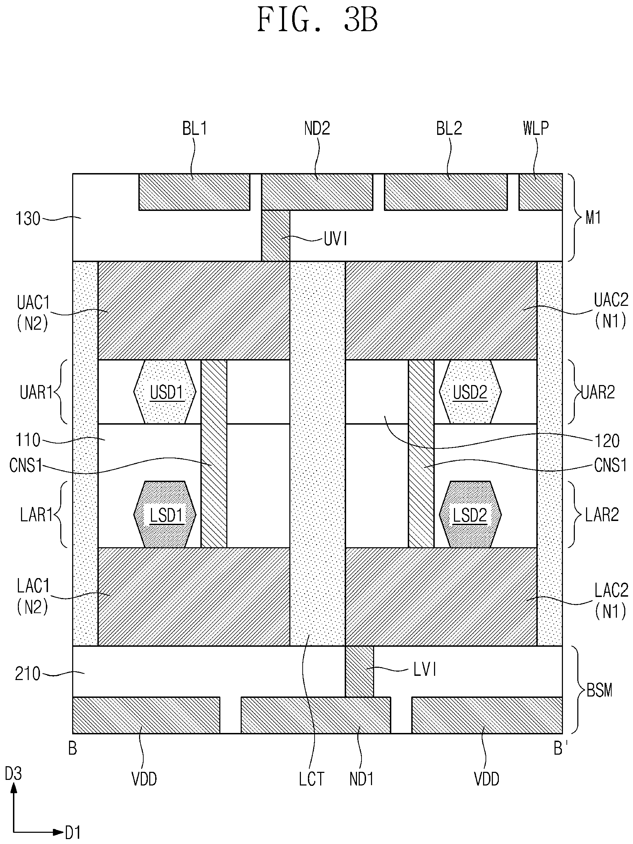

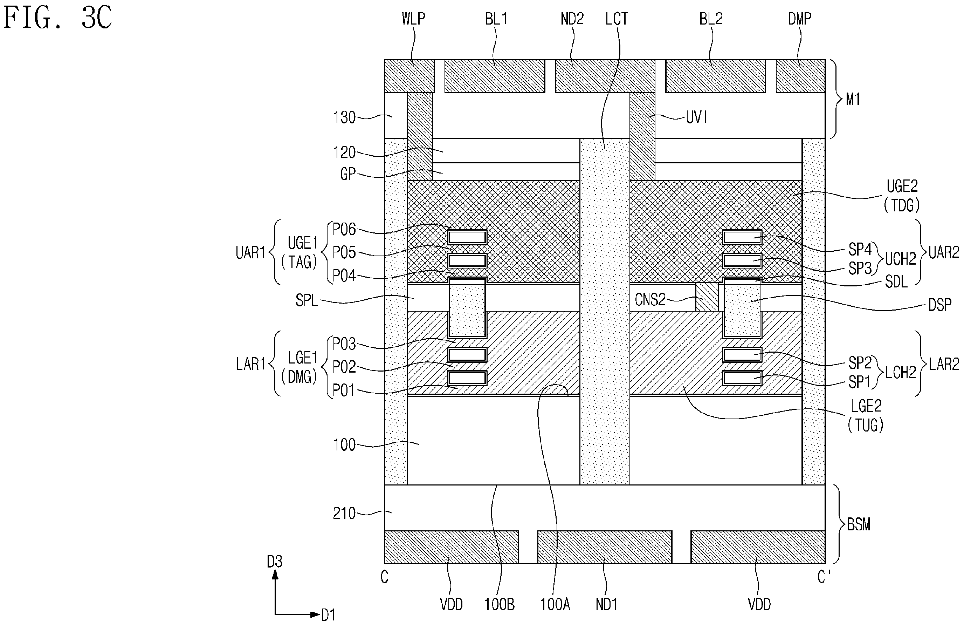

FIG. 2A is a plan view illustrating a first surface 100A of a substrate in a semiconductor memory device according to an embodiment of the inventive concept. FIG. 2B is a plan view illustrating a second surface 100B of a substrate in a semiconductor memory device according to an embodiment of the inventive concept. FIG. 3A is a cross-sectional view taken along a line A-A' of FIGS. 2A and 2B. FIG. 3B is a cross-sectional view taken along a line B-B' of FIGS. 2A and 2B. FIG. 3C is a cross-sectional view taken along a line C-C' of FIGS. 2A and 2B. In the present embodiment, each of first to fourth bit cells CE1 to CE4 may include an SRAM cell according to the circuit diagram of FIG. 1.

Referring to FIGS. 1, 2A, 2B, 3A, 3B, and 3C, a substrate 100 including a first surface 100A and a second surface 100B, opposite the first surface 100A, may be provided. The first surface 100A may be a front (or upper) surface of the substrate 100, and the second surface 100B may be a rear (or lower) surface of the substrate 100. In an embodiment, the substrate 100 may be formed of or include at least one of insulating substrates (e.g., silicon-based insulating materials). In an embodiment, the substrate 100 may be a semiconductor substrate made of silicon, germanium, or silicon germanium.

A lower active region LAR and an upper active region UAR may be sequentially stacked on the first surface 100A of the substrate 100 in a third direction D3 (i.e., vertical direction). The third direction D3 (the vertical direction) may be perpendicular to the first surface 100A of the substrate 100. In an embodiment, the lower active region LAR may be a PMOSFET region, and the upper active region UAR may be an NMOSFET region. The lower active region LAR may be provided as a bottom tier of the front-end-of-line (FEOL) layer, and the upper active region UAR may be provided as a top tier of the FEOL layer. The PMOSFET and NMOSFET of the lower and upper active regions LAR and UAR may be vertically stacked (i.e., in the third direction D3) to constitute transistors, which are three-dimensionally stacked.

The terms "upper" and "lower" may refer to relative positions along a particular direction (e.g. a vertical direction, such as the third direction D3). The same applies to relative terms such as "front" and "back". Various directions (e.g. vertical direction, horizontal direction, etc.) may be defined relative to the structure of the devices described herein. It will be appreciated that these directions do not necessarily imply any particular orientation of the device in use. The terms "upper", "lower", "front", "back" etc. may be replaced with terms, such as "first", "second", "third", etc. to be used to describe relative positions of elements. The terms "first", "second", third" may be used to describe various elements but the elements are not limited by the terms and a "first element" may be referred to as a "second element". Alternatively or additionally, the terms "first", "second", "third", etc. may be used to distinguish components from each other and do not limit the present disclosure. For example, the terms "first", "second", "third", etc. may not necessarily involve an order or a numerical meaning of any form.

When viewed in a plan view (e.g. viewed along the third direction D3), the lower active region LAR may extend in a second direction D2. The second direction D2 may be perpendicular to the third direction D3 (e.g. may be parallel to the first surface 100A of the substrate 100). The lower active region LAR may include lower channel patterns LCH and lower source/drain patterns LSD. The lower channel pattern LCH may be interposed between a pair of the lower source/drain patterns LSD. The lower channel pattern LCH may connect the pair of the lower source/drain patterns LSD to each other.

The lower channel pattern LCH may include a first semiconductor pattern SP1 and a second semiconductor pattern SP2, which are stacked to be spaced apart from each other in the third direction D3. Each of the first and second semiconductor patterns SP1 and SP2 may be formed of or include at least one of silicon (Si), germanium (Ge), or silicon germanium (SiGe). In an embodiment, each of the first and second semiconductor patterns SP1 and SP2 may be formed of or include crystalline silicon.

The lower source/drain pattern LSD may be an epitaxial pattern, which is formed by a selective epitaxial growth (SEG) process. In an embodiment, a top surface of the lower source/drain pattern LSD may be higher than a top surface of the second semiconductor pattern SP2 of the lower channel pattern LCH, in the third direction D3, relative to the first surface 100A of the substrate.

The lower source/drain pattern LSD may be doped with impurities to have a first conductivity type. In an embodiment, the first conductivity type may be a p type. The lower source/drain pattern LSD may be formed of or include silicon (Si) and/or silicon germanium (SiGe).

A lower active contact LAC may be provided on the lower source/drain pattern LSD. The lower active contact LAC may be electrically connected to the lower source/drain pattern LSD. In an embodiment, the lower active contact LAC may be provided below the lower source/drain pattern LSD in the third direction D3. When viewed in a plan view, the lower active contact LAC may be a bar-shaped pattern extending in a first direction D1 (e.g., see FIG. 2B). The first direction D1 may be perpendicular to the third direction D3. The first direction D1 may intersect (e.g. may be perpendicular to) the second direction D2. The first direction D1 and second direction D2 may be horizontal directions (e.g. may be parallel to the first surface 100A of the substrate 100).

In an embodiment, the lower active contact LAC may be formed of or include a metallic material that is selected from the group consisting of copper (Cu), aluminum (Al), ruthenium (Ru), cobalt (Co), tungsten (W), and molybdenum (Mo). The lower active contact LAC may be buried in the substrate 100.

A second interlayer insulating layer 120 and the upper active region UAR may be provided on a first interlayer insulating layer 110. The upper active region UAR may include upper channel patterns UCH and upper source/drain patterns USD. The upper channel patterns UCH may be vertically overlapped (i.e., in the third direction D3) with the lower channel patterns LCH, respectively. The upper source/drain patterns USD may be vertically overlapped with the lower source/drain patterns LSD, respectively. The term "overlap" (or "overlapping," or like terms), as may be used herein, is intended to broadly refer to a first element that intersects with at least a portion of a second element in the vertical direction (i.e., in the third direction D3, perpendicular to the first surface 100A of the substrate 100), but does not require that the first and second elements be completely aligned with one another in a horizontal plane (i.e., in the first direction D1 and/or second direction D2; parallel to the first surface 100A of the substrate 100); that is, components or layers described with reference to "overlap" in a particular direction may be at least partially obstructed by one another when viewed along a line extending in the particular direction. The upper channel pattern UCH may be interposed between a pair of the upper source/drain patterns USD in the second direction D2. The upper channel pattern UCH may connect the paired upper source/drain patterns USD to each other.

The upper channel pattern UCH may include a third semiconductor pattern SP3 and a fourth semiconductor pattern SP4, which are stacked to be spaced apart from each other in the third direction D3. The third and fourth semiconductor patterns SP3 and SP4 of the upper channel pattern UCH may include the same semiconductor material as the first and second semiconductor patterns SP1 and SP2 of the lower channel pattern LCH.

At least one dummy channel pattern DSP may be interposed between the lower channel pattern LCH and the upper channel pattern UCH thereon. A seed layer SDL may be interposed between the dummy channel pattern DSP and the upper channel pattern UCH.

The dummy channel pattern DSP may be spaced apart from the lower and upper source/drain patterns LSD and USD in the third direction D3. In other words, the dummy channel pattern DSP may not be connected to any source/drain pattern. The dummy channel pattern DSP may be formed of or include at least one of semiconductor materials (e.g., silicon (Si), germanium (Ge), or silicon germanium (SiGe)) or silicon-based insulating materials (e.g., silicon oxide or silicon nitride). In an embodiment, the dummy channel pattern DSP may be formed of or include at least one of the silicon-based insulating materials.

The upper source/drain patterns USD may be provided on a top surface of the first interlayer insulating layer 110. The upper source/drain pattern USD may be an epitaxial pattern formed by a selective epitaxial growth (SEG) process. In an embodiment, a top surface of the upper source/drain pattern USD may be higher than a top surface of the fourth semiconductor pattern SP4 of the upper channel pattern UCH in the third direction D3.

The upper source/drain patterns USD may be doped with impurities to have a second conductivity type. The second conductivity type may be an n type. The upper source/drain patterns USD may be formed of or include at least one of silicon germanium (SiGe) and/or silicon (Si).

The second interlayer insulating layer 120 may cover the upper source/drain patterns USD. The term "cover" (or "covers" or "covering" or like terms) as may be used herein is intended to broadly refer to a material, layer or structure being on or over another material, layer or structure, but does not require the material, layer or structure to *entirely* cover the other material, layer or structure. A top surface of the second interlayer insulating layer 120 may be coplanar, in the third direction D3, with top surfaces of upper active contacts UAC, which will be described below.

The upper active contact UAC may be provided on the upper source/drain pattern USD. The upper active contact UAC may be electrically connected to the upper source/drain pattern USD. In an embodiment, the upper active contact UAC may be provided on the upper source/drain pattern USD. When viewed in a plan view, the upper active contact UAC may be a bar-shaped pattern extending in the first direction D1 (e.g., see FIG. 2A).

In an embodiment, the upper active contact UAC may be formed of or include a metallic material that is selected from the group consisting of copper (Cu), aluminum (Al), ruthenium (Ru), cobalt (Co), tungsten (W), and molybdenum (Mo). The upper active contact UAC may be provided in the second interlayer insulating layer 120.

Lower gate electrodes LGE may be provided on the lower channel patterns LCH, respectively. Upper gate electrodes UGE may be provided on the upper channel patterns UCH, respectively. The lower gate electrode LGE may be provided in the bottom tier (i.e., the lower active region LAR). The upper gate electrode UGE may be provided in the top tier (i.e., the upper active region UAR). The upper gate electrode UGE may be vertically overlapped (i.e., in the third direction D3) with the lower gate electrode LGE therebelow. When viewed in a plan view, the lower and upper gate electrodes LGE and UGE, which are overlapped with each other, may be bar-shaped patterns extending in the first direction D1.

In an embodiment, a separation insulating layer SPL (FIG. 3C) may be interposed between the upper gate electrode UGE and the lower gate electrode LGE. The upper gate electrode UGE and the lower gate electrode LGE may be vertically spaced apart (i.e., in the third direction D3) from each other by the separation insulating layer SPL.

The lower gate electrode LGE may be provided on a top surface, a bottom surface, and opposite side surfaces of each of the first and second semiconductor patterns SP1 and SP2. The upper gate electrode UGE may be provided on a top surface, a bottom surface, and opposite side surfaces of each of the third and fourth semiconductor patterns SP3 and SP4. That is, the transistor according to the present embodiment may include a three-dimensional field effect transistor (e.g., MBCFET or GAAFET) in which a gate electrode is provided to three-dimensionally surround a channel pattern.

The lower gate electrode LGE may include a first portion PO1 interposed between the first surface 100A of the substrate 100 and the first semiconductor pattern SP1, a second portion PO2 interposed between the first semiconductor pattern SP1 and the second semiconductor pattern SP2, and a third portion PO3 interposed between the second semiconductor pattern SP2 and the dummy channel pattern DSP.

The upper gate electrode UGE may include a fourth portion PO4 interposed between the dummy channel pattern DSP (or the seed layer SDL) and the third semiconductor pattern SP3, a fifth portion PO5 interposed between the third semiconductor pattern SP3 and the fourth semiconductor pattern SP4, and a sixth portion PO6 on the fourth semiconductor pattern SP4.

A pair of gate spacers GS (FIG. 3A) may be respectively disposed on opposite side surfaces of the upper gate electrode UGE. The gate spacers GS may extend along a sidewall of the upper gate electrode UGE and in the first direction D1. Top surfaces of the gate spacers GS may be higher than a top surface of the upper gate electrode UGE in the third direction D3. In an embodiment, the top surfaces of the gate spacers GS may be lower than the top surface of the second interlayer insulating layer 120 relative to the first surface 100A of the substrate 100. The gate spacers GS may be formed of or include at least one of SiCN, SiCON, or SiN. In an embodiment, the gate spacers GS may have a multi-layered structure, which is formed of or includes at least two different materials selected from SiCN, SiCON, and SiN.

A gate capping pattern GP may be provided on the top surface of the upper gate electrode UGE. The gate capping pattern GP may extend along the upper gate electrode UGE and in the first direction D1. For example, the gate capping pattern GP may be formed of or include at least one of SiON, SiCN, SiCON, or SiN.

A gate insulating layer GI may be interposed between the lower gate electrode LGE and the first and second semiconductor patterns SP1 and SP2. The gate insulating layer GI may be interposed between the upper gate electrode UGE and the third and fourth semiconductor patterns SP3 and SP4. The gate insulating layer GI may be interposed between the lowermost portion (e.g., the first portion PO1) of the lower gate electrode LGE and the substrate 100. The gate insulating layer GI may be interposed between an inner electrode (e.g., PO1 to PO3) of the lower gate electrode LGE and the lower source/drain pattern LSD. The gate insulating layer GI may be interposed between an inner electrode (e.g., PO4 and PO5) of the upper gate electrode UGE and the upper source/drain pattern USD. The gate insulating layer GI may be interposed between an outer electrode (e.g., PO6) of the upper gate electrode UGE and the gate spacer GS.

The gate insulating layer GI may include a silicon oxide layer, a silicon oxynitride layer, and/or a high-k dielectric layer. In an embodiment, the gate insulating layer GI may include a silicon oxide layer, which is formed to directly cover a surface of one of the semiconductor patterns SP1 to SP4, and a high-k dielectric layer, which is formed on the silicon oxide layer. That is, the gate insulating layer GI may have a multi-layered structure including the silicon oxide layer and the high-k dielectric layer.

The high-k dielectric layer may be formed of or include at least one high-k dielectric material that has a dielectric constant that is higher than that of silicon oxide. For example, the high-k dielectric material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

The lower gate electrode LGE may include a first work function metal on the first and second semiconductor patterns SP1 and SP2. The upper gate electrode UGE may include a second work function metal on the third to fourth semiconductor patterns SP3 and SP4. As an example, the first work function metal may include a metal nitride material (e.g., TiN), which is used as a p-type work function metal. The second work function metal may include a metal carbide material (e.g., TiC, AlC, or TiAlC), which is used as an n-type work function metal.

A cutting structure LCT may extend in the second direction D2 to cross a center of each of the bit cells CE1 to CE4. Referring back to FIGS. 3B and 3C, the cutting structure LCT may vertically extend from the upper active contact UAC to the lower active contact LAC. The cutting structure LCT may be provided to penetrate (i.e., extend into) the upper active contact UAC, the upper gate electrode UGE, and the lower gate electrode LGE, and the lower active contact LAC. The term "penetrate" (or "penetrates" or "penetrating," or like terms) is intended to broadly refer to one element (e.g., layer, region, structure, etc.) extending into another element, either partially or entirely therethrough. The cutting structure LCT may be formed of or include at least one of insulating materials (e.g., silicon oxide, silicon nitride, or combinations thereof).

The upper active contact UAC may be divided into a first upper active contact UAC1 and a second upper active contact UAC2, which are adjacent to each other in the first direction D1, by the cutting structure LCT. In other words, the upper active contact UAC may comprise the first upper active contact UAC1 and the second upper active contact UAC2, the first and second upper active contacts UAC1, UAC2 separated from one another by the cutting structure LCT. Similarly, the upper gate electrode UGE may be divided into a first upper gate electrode UGE1 and a second upper gate electrode UGE2, which are adjacent to each other in the first direction D1, by the cutting structure LCT. The lower gate electrode LGE may be divided into a first lower gate electrode LGE1 and a second lower gate electrode LGE2, which are adjacent to each other in the first direction D1, by the cutting structure LCT. The lower active contact LAC may be divided into a first lower active contact LAC1 and a second lower active contact LAC2, which are adjacent to each other in the first direction D1, by the cutting structure LCT.

A first connection structure CNS1 may be provided between the upper active contact UAC and the lower active contact LAC, which are vertically overlapped with each other in the third direction D3. The first connection structure CNS1 may be provided to electrically connect the upper active contact UAC to the lower active contact LAC in a vertical direction (e.g., see FIG. 3B).

A second connection structure CNS2 may be provided between the upper gate electrode UGE and the lower gate electrode LGE, which are vertically overlapped with each other in the third direction D3. The second connection structure CNS2 may be provided to electrically connect the upper gate electrode UGE to the lower gate electrode LGE in a vertical direction (e.g., see FIG. 3C).

A lower interlayer insulating layer 210 may be provided on the second surface 100B of the substrate 100. A back-side metal layer BSM may be provided in the lower interlayer insulating layer 210. The back-side metal layer BSM may include power lines VDD, ground lines VSS, and first shared pads ND1. Each of the interconnection lines in the back-side metal layer BSM may be formed of or include a metallic material that is selected from the group consisting of copper (Cu), aluminum (Al), ruthenium (Ru), cobalt (Co), tungsten (W), and molybdenum (Mo).

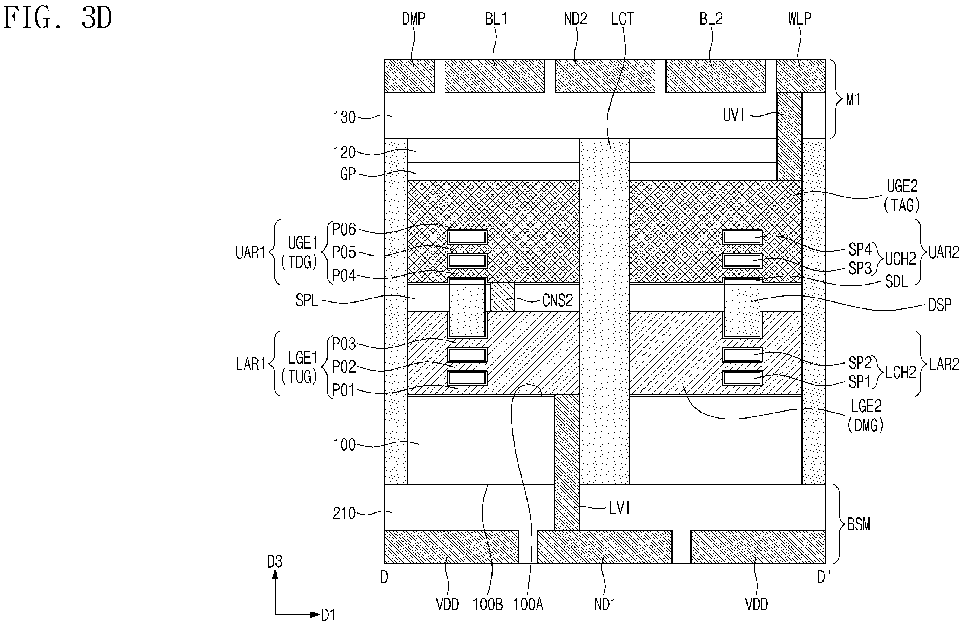

Lower vias LVI may be provided on the back-side metal layer BSM. One of the lower vias LVI may be provided to penetrate (i.e., extend into) the lower interlayer insulating layer 210 and the substrate 100 and may be connected to the lower gate electrode LGE (e.g., see FIG. 3D). Another one of the lower vias LVI may be provided to penetrate (i.e., extend into) the lower interlayer insulating layer 210 and may be connected to the lower active contact LAC (e.g., see FIG. 3B). For example, the lower via LVI may be formed of or include a metallic material that is selected from the group consisting of copper (Cu), aluminum (Al), ruthenium (Ru), cobalt (Co), tungsten (W), and molybdenum (Mo).

A power delivery network layer may be further provided below the back-side metal layer BSM. The power delivery network layer may include a plurality of lower interconnection lines, which are electrically connected to the ground and power lines VSS and VDD. In an embodiment, the power delivery network layer may include an interconnection network, which is configured to apply a ground voltage to the ground lines VSS. The power delivery network layer may include an interconnection network, which is configured to apply a power voltage to the power lines VDD.

A third interlayer insulating layer 130 may be provided on the second interlayer insulating layer 120. A first metal layer M1 may be provided in the third interlayer insulating layer 130. The first metal layer M1 may include first and second bit lines BL1 and BL2, second shared pads ND2, word line pads WLP, and dummy pads DMP. Each of interconnection lines in the first metal layer M1 may be formed of or include a metallic material that is selected from the group consisting of copper (Cu), aluminum (Al), ruthenium (Ru), cobalt (Co), tungsten (W), and molybdenum (Mo).

Upper vias UVI may be provided below the first metal layer M1. One of the upper vias UVI may be provided to penetrate (i.e., extend into) the third interlayer insulating layer 130, the second interlayer insulating layer 120, and the gate capping pattern GP and may be connected to the upper gate electrode UGE (e.g., see FIG. 3C). Another one of the upper vias UVI may be provided to penetrate (i.e., extend into) the third interlayer insulating layer 130 and may be connected to the upper active contact UAC (e.g., see FIG. 3B). For example, the upper via UVI may be formed of or include a metallic material that is selected from the group consisting of copper (Cu), aluminum (Al), ruthenium (Ru), cobalt (Co), tungsten (W), and molybdenum (Mo).

Additional metal layers (e.g., M2, M3, M4, and so forth) may be stacked on the first metal layer M1. The first metal layer M1 and the additional metal layers (e.g., M2, M3, M4, and so forth) thereon may constitute a back-end-of-line (BEOL) layer of the semiconductor device.

In an embodiment, the power line, which is configured to supply ground and power voltages to the bit cells CE1 to CE4, may be provided in the form of the power delivery network layer and may be disposed below the substrate 100. Thus, the power line may be omitted from the BEOL layer including the first metal layer M1. Since the power line is omitted from the BEOL layer, the complexity of the interconnection lines in the BEOL layer may be lowered. In addition, by increasing the size of the interconnection lines in the BEOL layer, it may be possible to reduce the electrical resistance of the interconnection lines in the BEOL layer.

Referring back to FIGS. 2A and 2B, the bit cells CE1 to CE4 may be provided on the substrate 100. The bit cells CE1 to CE4 may include the first to fourth bit cells CE1 to CE4, which are arranged in the form of 2 X 2 array. Each of the first to fourth bit cells CE1 to CE4 may be an SRAM cell previously described with reference to FIG. 1.

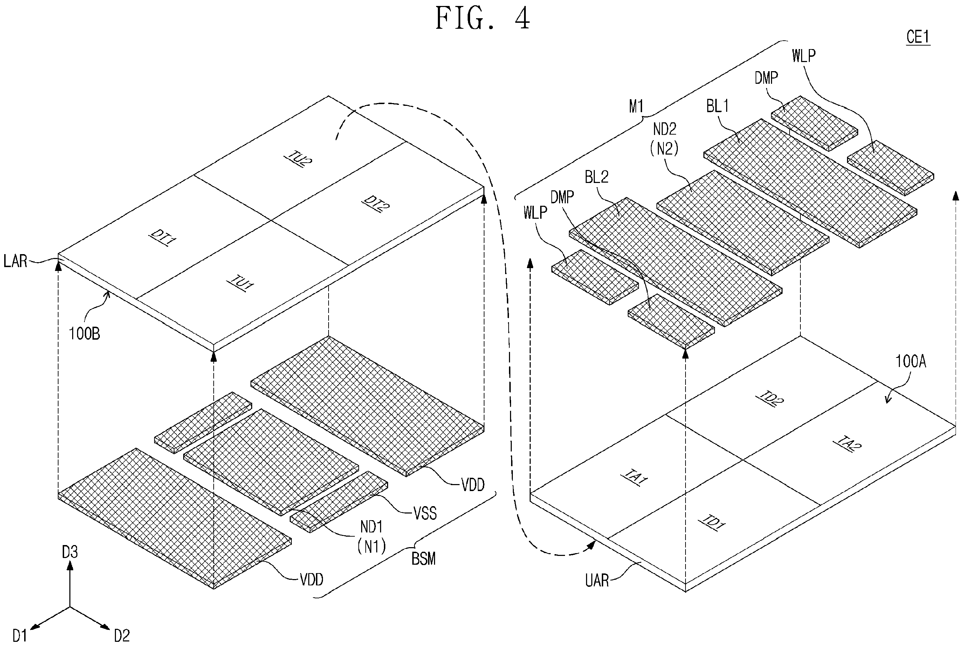

FIG. 4 is a perspective view illustrating layers constituting a first bit cell according to an embodiment of the inventive concept. Hereinafter, one of the bit cells (e.g., the first bit cell CE1) will be described in more detail with reference to FIG. 4.

The substrate 100 may include the first surface 100A and the second surface 100B, which are opposite to each other. The first surface 100A may be a front surface of the substrate 100. The second surface 100B may be a rear surface of the substrate 100.

The first metal layer M1 may be provided on the first surface 100A of the substrate 100. The first metal layer M1 may be the lowermost metal layer of the BEOL layer. The back-side metal layer BSM may be provided on the second surface 100B of the substrate 100. The back-side metal layer BSM may be the uppermost metal layer of a backside power delivery network. Each of the first and back-side metal layers M1 and BSM, respectively, may be formed of or include at least one of conductive metal nitride materials (e.g., titanium nitride or tantalum nitride) or metallic materials (e.g., titanium, tantalum, tungsten, copper, or aluminum).

The back-side metal layer BSM may include the power lines VDD, which extend in the second direction D2. Each of the power lines VDD may be a line-shaped pattern extending in the second direction D2. The back-side metal layer BSM may further include the ground lines VSS and the first shared pad ND1, which are provided between the power lines VDD. When viewed in a plan view, the ground lines VSS and the first shared pad ND1 may have an island shape. The first shared pad ND1 may correspond to the first node N1 of FIG. 1.

The first metal layer M1 may include the first bit line BL1 and the second bit line BL2, which extend in the second direction D2. When viewed in a plan view, each of the first and second bit lines BL1 and BL2 may be a line-shaped pattern extending in the second direction D2.

The first metal layer M1 may include the word line pads WLP and the dummy pads DMP. In an embodiment, the word line pad WLP and the dummy pad DMP may be provided at a side on each of the first and second bit lines BL1 and BL2. The word line pads WLP and the dummy pads DMP may be arranged in the second direction D2. When viewed in a plan view, the word line pads WLP and the dummy pads DMP may have an island shape. Although not explicitly shown, the word line pad WLP may be electrically connected to the word line WL in a second metal layer M2. Each dummy pad DMP may be a floated metal pattern.

The first metal layer M1 may further include the second shared pad ND2, which is provided between the first and second bit lines BL1 and BL2. When viewed in a plan view, the second shared pad ND2 may have an island shape. The second shared pad ND2 may correspond to the second node N2 of FIG. 1.

The first shared pad ND1 and the second shared pad ND2 may be vertically overlapped with each other (e.g., see FIGS. 3B and 4). An area of the first shared pad ND1 may be different from an area of the second shared pad ND2 when viewed in a plan view (i.e., in the first direction D1 and second direction D2). The first shared pad ND1 may electrically connect one of the upper active contacts UAC to one of the upper gate electrodes UGE. The second shared pad ND2 may electrically connect one of the lower active contacts LAC to one of the lower gate electrodes LGE.

According to an embodiment of the inventive concept, both the ground and power lines VSS and VDD may be omitted from the BEOL layer, which includes the first metal layer M1 and is provided on the first surface 100A. The BEOL layer (e.g., the first metal layer M1) on the first surface 100A may be composed of bit lines BL and word lines WL.

The first bit cell CE1 may include the lower active region LAR serving as the bottom tier and the upper active region UAR serving as the top tier. Four PMOSFETs, which are arranged in the form of a 2 X 2 array, may be provided in the lower active region LAR. In detail, the lower active region LAR may include a first pull-up transistor TU1, a second pull-up transistor TU2, a first dummy transistor DT1, and a second dummy transistor DT2.

Four NMOSFETs, which are arranged in the form of a 2 X 2 array, may be provided in the upper active region UAR. In detail, the upper active region UAR may include the first pull-down transistor TD1, the second pull-down transistor TD2, the first pass-gate transistor TA1, and the second pass-gate transistor TA2.

The upper active region UAR may be disposed on and overlapped with the lower active region LAR. Thus, the first pull-down transistor TD1 and the first pull-up transistor TU1 may be vertically overlapped with each other. The second pull-down transistor TD2 and the second pull-up transistor TU2 may be vertically overlapped with each other. The first pass-gate transistor TA1 and the first dummy transistor DT1 may be vertically overlapped with each other. The second pass-gate transistor TA2 and the second dummy transistor DT2 may be vertically overlapped with each other.

Referring to FIGS. 3B and 3D, the second lower active contact LAC2 and the second upper active contact UAC2 may be electrically connected to each other through the first connection structure CNS1. The second lower active contact LAC2 may be electrically connected to the first shared pad ND1 through the lower via LVI. As a result, they may constitute the first node N1 of FIG. 1.

The first lower gate electrode LGE1 and the first upper gate electrode UGE1 may be electrically connected to each other through the second connection structure CNS2. The first shared pad ND1 may be connected to the first lower gate electrode LGE1 through another one of the lower vias LVI. That is, a gate TUG of the pull-up transistor and a gate TDG of the pull-down transistor may be connected to the first node N1 through the first shared pad ND1.

Referring to FIGS. 3B and 3C, the first lower active contact LAC1 and the first upper active contact UAC1 may be electrically connected to each other through the first connection structure CNS1. The first upper active contact UAC1 may be electrically connected to the second shared pad ND2 through the upper via UVI. As a result, they may constitute the second node N2 of FIG. 1.

The second lower gate electrode LGE2 and the second upper gate electrode UGE2 may be electrically connected to each other through the second connection structure CNS2. The second shared pad ND2 may be connected to the second upper gate electrode UGE2 through another one of the upper vias UVI. That is, the gate TUG of the pull-up transistor and the gate TDG of the pull-down transistor may be connected to the second node N2 through the second shared pad ND2.

As illustrated in FIG. 3C, the upper gate electrode UGE corresponding to a gate TAG of the pass-gate transistor TA1 or TA2 may be connected to a word line pad WLP1 or WLP2. The lower gate electrode LGE corresponding to a gate DMG of the dummy transistor DT1 or DT2 may be vertically overlapped with the upper gate electrode UGE corresponding to the gate TAG of the pass-gate transistor TA1 or TA2. The lower gate electrode LGE corresponding to the gate DMG of the dummy transistor DT1 or DT2 may be in an electrically floating state.

In the present embodiment, the first and second nodes N1 and N2 of the bit cell CE1, CE2, CE3, or CE4 may be separately disposed in the back-side metal layer BSM and the first metal layer M1, respectively. That is, the first node N1 and the second node N2 may be separately disposed on the rear and front surfaces 100B and 100A of the substrate 100, respectively. Thus, an area of the bit cell CE1, CE2, CE3, or CE4 may be decreased, and in this case, an integration density of the device may be increased.

One of the bit cells (e.g., the first bit cell CE1) will be described in more detail with reference to FIGS. 2A, 2B, 3A to 3D, and 4. The second bit cell CE2 and the first bit cell CE1 may be disposed to exhibit symmetry with respect to a cell boundary between the first and second bit cells CE1 and CE2 in the first direction D1. For example, the back-side metal layer BSM of the second bit cell CE2 may be symmetrical with respect to the back-side metal layer BSM of the first bit cell CE1 shown in FIG. 4. The lower active region LAR of the second bit cell CE2 may be symmetrical with respect to the lower active region LAR of the first bit cell CE1 shown in FIG. 4. The upper active region UAR of the second bit cell CE2 may be symmetrical with respect to the upper active region UAR of the first bit cell CE1 shown in FIG. 4. The first metal layer M1 of the second bit cell CE2 may be symmetrical with respect to the first metal layer M1 of the first bit cell CE1 shown in FIG. 4.

The third bit cell CE3 and the first bit cell CE1 may be disposed to exhibit symmetry with respect to a cell boundary between the first and third bit cells CE1 and CE3 in the second direction D2. The fourth bit cell CE4 may be disposed in a point-symmetrical manner with respect to the first bit cell CE1 around a center point of a structure composed of the first to fourth bit cells CE1 to CE4.

FIGS. 5A to 9C are cross-sectional views illustrating intermediate processes in an example method of fabricating a semiconductor memory device according to an embodiment of the inventive concept. FIGS. 5A, 6A, 7A, 8A, and 9A are cross-sectional views taken along the line A-A' of FIGS. 2A and 2B. FIGS. 7B, 8B, and 9B are cross-sectional views taken along the line B-B' of FIGS. 2A and 2B. FIGS. 5B, 6B, 8C and 9C are cross-sectional views taken along the line C-C' of FIGS. 2A and 2B.

Referring to FIGS. 5A and 5B, a semiconductor substrate 105 including the first to fourth bit cells CE1 to CE4 may be provided. The semiconductor substrate 105 may be formed of or include at least one of silicon (Si), germanium (Ge), or silicon-germanium (SiGe).

First sacrificial layers SAL1 and first active layers ACL1 may be alternatively stacked on the semiconductor substrate 105 in the third direction D3. The first sacrificial layers SAL1 and the first active layers ACL1 may be formed of or include at least one of silicon (Si), germanium (Ge), or silicon germanium (SiGe) and may be formed of different materials from each other. For example, the first sacrificial layers SAL1 may be formed of or include silicon germanium (SiGe), and the first active layers ACL1 may be formed of or include silicon (Si). A germanium concentration of each of the first sacrificial layers SAL1 may range from about 10 atomic percent (at%) to 30 at%.

A separation layer DSL may be formed on the uppermost one of the first sacrificial layers SAL1. In an embodiment, a cross-sectional thickness (in the third direction D3) of the separation layer DSL may be larger than a cross-sectional thickness of the first sacrificial layer SAL1. The separation layer DSL may be formed of or include silicon (Si) or silicon germanium (SiGe). In the case where the separation layer DSL includes silicon germanium (SiGe), a germanium concentration of the separation layer DSL may be higher than the germanium concentration of the first sacrificial layer SAL1. For example, the germanium concentration of the separation layer DSL may range from about 40 at% to 90 at%.

The seed layer SDL may be formed on the separation layer DSL. The seed layer SDL may be formed of or include the same material as the first active layer ACL1, although embodiments of the inventive concept are not limited thereto. Second sacrificial layers SAL2 and second active layers ACL2 may be alternatively stacked on the seed layer SDL in the third direction D3. Each of the second sacrificial layers SAL2 may be formed of or include the same material as the first sacrificial layer SAL1, and each of the second active layers ACL2 may be formed of or include the same material as the first active layer ACL1. The separation layer DSL may be interposed between the first sacrificial layer SAL1 and the seed layer SDL.

A stacking pattern STP may be formed by patterning the first and second sacrificial layers SAL1 and SAL2, the first and second active layers ACL1 and ACL2, and the separation layer DSL which are stacked. The formation of the stacking pattern STP may include forming a hard mask pattern on the uppermost one of the second active layers ACL2, and etching the layers SAL1, SAL2, ACL1, ACL2, SDL, and DSL, which are stacked on the semiconductor substrate 105, using the hard mask pattern as an etch mask. During the formation of the stacking pattern STP, an upper portion of the semiconductor substrate 105 may be patterned to form a trench TR defining active patterns AP1 and AP2.

The stacking pattern STP may be a bar-shaped pattern extending in the second direction D2. The active patterns AP1 and AP2 may include a first active pattern AP1 and a second active pattern AP2. The first and second active patterns AP1 and AP2 may be spaced apart from each other in the first direction D1. Each of the first and second active patterns AP1 and AP2 may be vertically overlapped (i.e., in the third direction D3) with the stacking pattern STP.

The stacking pattern STP may include a lower stacking pattern STP1 on the active pattern AP1 or AP2, an upper stacking pattern STP2 on the lower stacking pattern STP1, and the separation layer DSL between the lower and upper stacking patterns STP1 and STP2. The lower stacking pattern STP1 may include the first sacrificial layers SAL1 and the first active layers ACL1 which are alternately stacked in the third direction D3. The upper stacking pattern STP2 may include the seed layer SDL and the second sacrificial and active layers SAL2 and ACL2, which are alternatingly stacked on the seed layer SDL in the third direction D3.

A device isolation layer ST may be formed on the semiconductor substrate 105 to at least partially fill the trench TR. The term "fill" (or "filling," "filled," or like terms) as may be used herein is intended to refer broadly to either completely filling a defined space (e.g., trench TR) or partially filling the defined space; that is, the defined space need not be entirely filled but may, for example, be partially filled or have voids or other spaces throughout. In detail, an insulating layer may be formed on a front surface of the semiconductor substrate 105 to cover the first and second active patterns AP1 and AP2 and the stacking patterns STP. The device isolation layer ST may be formed by recessing the insulating layer until the stacking patterns STP are exposed.

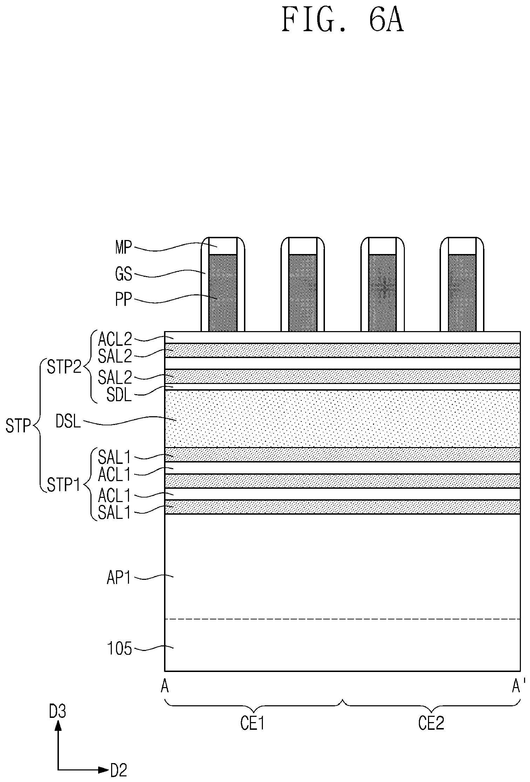

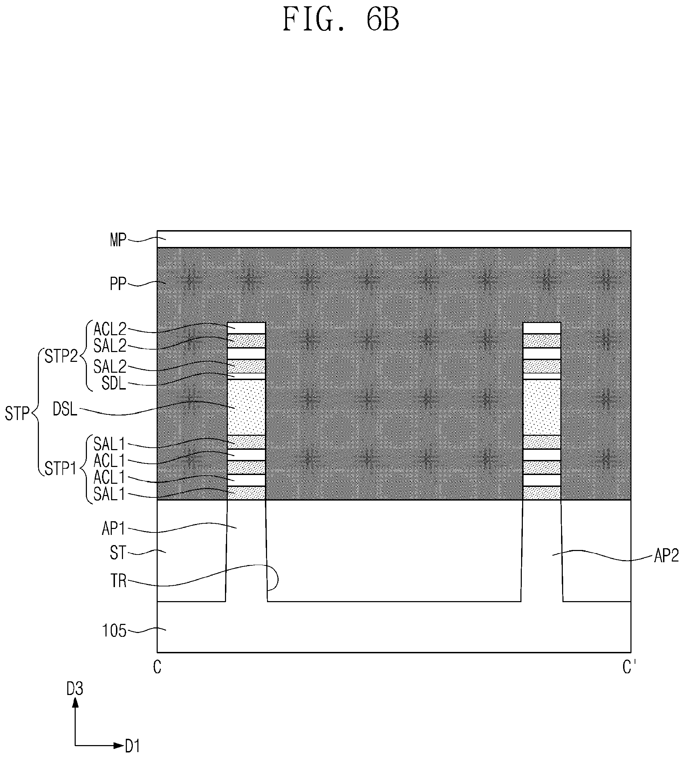

Referring to FIGS. 6A and 6B, a plurality of sacrificial patterns PP may be formed to cross the stacking pattern STP. Each of the sacrificial patterns PP may be formed to have a line shape extending in the first direction D1, perpendicular to the stacking patterns STP, which extend in the second direction D2. In detail, the formation of the sacrificial patterns PP may include forming a sacrificial layer on the front surface of the semiconductor substrate 105, forming a hard mask pattern MP on the sacrificial layer, and patterning the sacrificial layer using the hard mask pattern MP as an etch mask. The sacrificial layer may be formed of or include amorphous silicon and/or polysilicon.

A pair of the gate spacers GS may be respectively formed on opposite side surfaces (i.e. sidewalls) of the sacrificial pattern PP. In detail, a spacer layer may be conformally formed on the front surface of the semiconductor substrate 105. The spacer layer may cover the sacrificial pattern PP and the hard mask pattern MP. For example, the spacer layer may be formed of or include at least one of SiCN, SiCON, or SiN. The gate spacers GS may be formed by anisotropically etching the spacer layer.

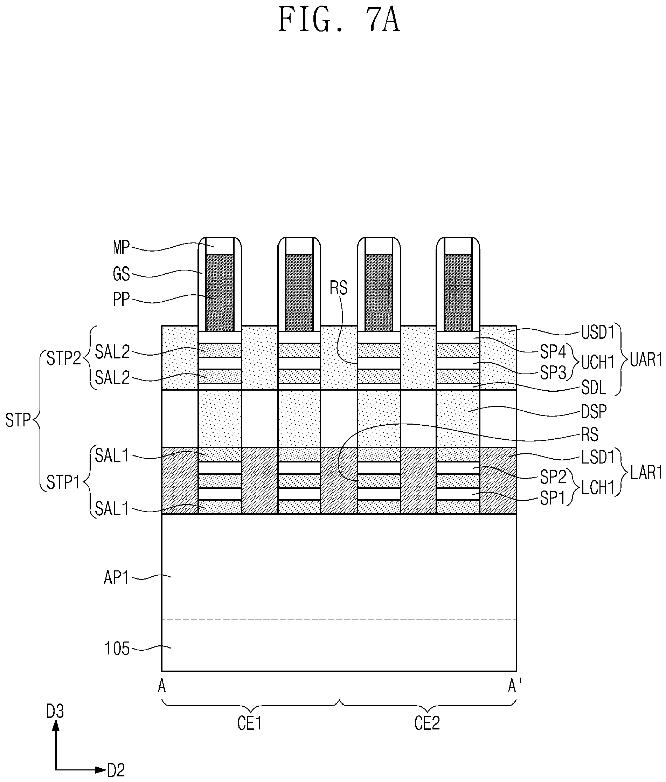

Referring to FIGS. 7A to 7B, an etching process using the gate spacers GS and the hard mask pattern MP as an etch mask may be performed on the stacking pattern STP. As a result of the etching process, a recess RS may be formed between the sacrificial patterns PP. The recess RS may be defined between the lower stacking patterns STP1, which are adjacent to each other in the second direction D2. The recess RS may be defined between the upper stacking patterns STP2, which are adjacent to each other in the second direction D2.

In the case where the separation layer DSL includes silicon germanium (SiGe), the separation layer DSL may be replaced with a silicon-based insulating material. The separation layer DSL exposed by the recess RS may be selectively removed, and the dummy channel pattern DSP may be formed in a region, which is formed by removing the separation layer DSL. The dummy channel pattern DSP may be formed of or include at least one of silicon-based insulating materials (e.g., silicon nitride).

The lower source/drain pattern LSD may be formed between the lower stacking patterns STP1. In detail, the lower source/drain pattern LSD may be formed by performing a first SEG process, in which an exposed side surface of the lower stacking pattern STP1 and an exposed top surface of the active pattern AP1 or AP are used as a seed layer. The lower source/drain pattern LSD may be grown using the first active layers ACL1 and the active pattern AP1 or AP2, which are exposed by the recess RS, as a seed layer. As an example, the first SEG process may include a chemical vapor deposition (CVD) process or a molecular beam epitaxy (MBE) process.

In an embodiment, impurities may be injected into the lower source/drain pattern LSD in an in-situ manner during the first SEG process. In another embodiment, the impurities may be injected into the lower source/drain pattern LSD by an ion-implantation process that is performed after the formation of the lower source/drain pattern LSD. The lower source/drain pattern LSD may be doped to have a first conductivity type (e.g., an p-type).

The first active layers ACL1, which are interposed between the paired lower source/drain patterns LSD, may constitute the lower channel pattern LCH. That is, the first and second semiconductor patterns SP1 and SP2 of the lower channel pattern LCH may be formed from the first active layers ACL1. The lower channel patterns LCH and the lower source/drain patterns LSD may constitute the lower active region LAR serving as the bottom tier of the three-dimensional device.

The first interlayer insulating layer 110 may be formed on the lower source/drain patterns LSD. The first interlayer insulating layer 110 may be recessed to expose the upper stacking patterns STP2.

The upper source/drain pattern USD may be formed between the exposed upper stacking patterns STP2. In detail, the upper source/drain pattern USD may be formed by performing a second SEG process, in which a side surface of the upper stacking pattern STP2 is used as a seed layer. The upper source/drain pattern USD may be grown using the second active layers ACL2 and the seed layer SDL, which are exposed by the recess RS, as a seed layer. The upper source/drain pattern USD may be doped to have the second conductivity type (e.g., n-type), which is different from the first conductivity type.

The second active layers ACL2, which are interposed between the paired upper source/drain patterns USD, may constitute the upper channel pattern UCH. That is, the third and fourth semiconductor patterns SP3 and SP4 of the upper channel pattern UCH may be formed from the second active layers ACL2. The upper channel patterns UCH and the upper source/drain patterns USD may constitute the upper active region UAR serving as the top tier of the three-dimensional device.

The lower active region LAR may include a first lower active region LAR1 on the first active pattern AP1 and a second lower active region LAR2 on the second active pattern AP2. The upper active region UAR may include a first upper active region UAR1 on the first lower active region LAR1 and a second upper active region UAR2 on the second lower active region LAR2.

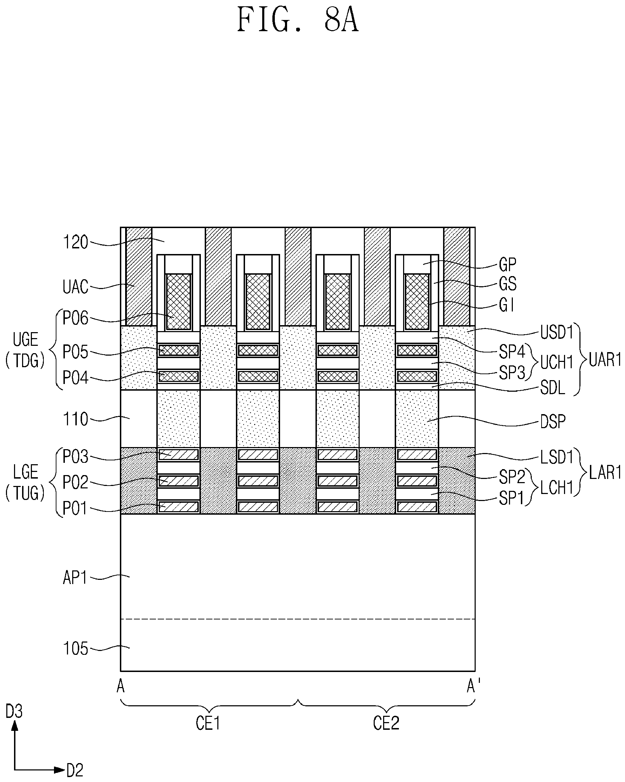

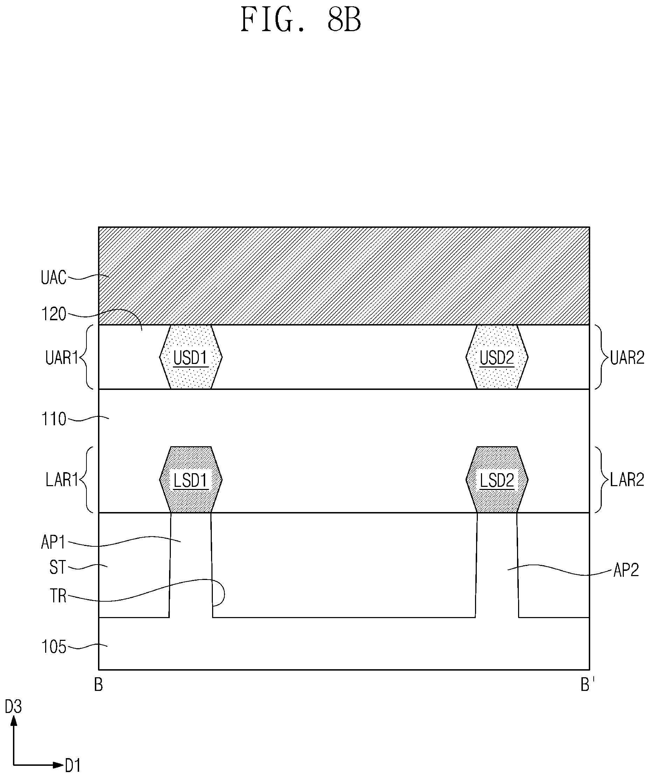

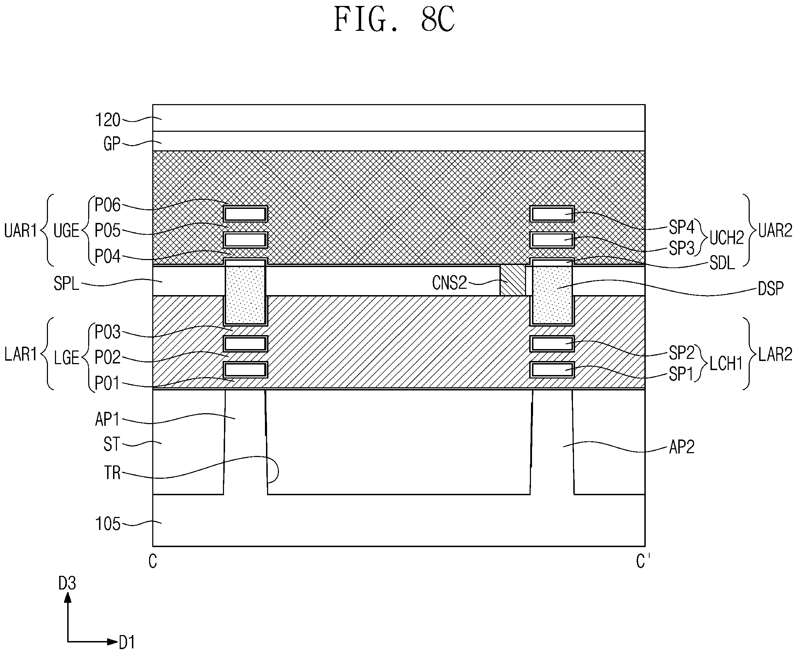

Referring to FIGS. 8A to 8C, the second interlayer insulating layer 120 may be formed on the upper source/drain patterns USD. The second interlayer insulating layer 120 may be planarized to expose a top surface of the sacrificial pattern PP. The planarization of the second interlayer insulating layer 120 may be performed using an etch-back process or a chemical mechanical polishing (CMP) process, although embodiments of the inventive concept are not limited thereto. The hard mask pattern MP may be fully removed during the planarization process. As a result, the top surface of the second interlayer insulating layer 120 may be coplanar with the top surface of the sacrificial pattern PP and the top surfaces of the gate spacers GS.

The exposed sacrificial pattern PP may be selectively removed. The removal of the sacrificial pattern PP may include a wet etching process using etching solution capable of selectively etching polysilicon. As a result of the removal of the sacrificial pattern PP, the first and second sacrificial layers SAL1 and SAL2 (see FIG. 7A) may be exposed.

An etching process may be performed to selectively etch the first and second sacrificial layers SAL1 and SAL2, and in this case, it may be possible to remove only the first and second sacrificial layers SAL1 and SAL2, while leaving the first to fourth semiconductor patterns SP1 to SP4 and the dummy channel pattern DSP. The etching process may be performed using an etch recipe having a high etch rate for a silicon germanium layer. For example, the etching process may exhibit a high etch rate for a silicon germanium layer that has a germanium concentration of 10 at% or higher.

The gate insulating layer GI may be conformally formed in a region that is formed by removing the sacrificial pattern PP and the first and second sacrificial layers SAL1 and SAL2. The lower gate electrode LGE may be formed on the gate insulating layer GI of the lower active region LAR. The lower gate electrode LGE may include the first portion PO1 between the active pattern AP1 or AP2 and the first semiconductor pattern SP1, the second portion PO2 between the first semiconductor pattern SP1 and the second semiconductor pattern SP2, and the third portion PO3 between the second semiconductor pattern SP2 and the dummy channel pattern DSP.

The separation insulating layer SPL may be formed on the lower gate electrode LGE. The second connection structure CNS2 may be formed to penetrate (i.e., extend into) the separation insulating layer SPL. In detail, the formation of the second connection structure CNS2 may include forming a penetration hole (i.e., opening) to penetrate the separation insulating layer SPL and expose the top surface of the lower gate electrode LGE and filling the penetration hole with a conductive material.

The upper gate electrode UGE may be formed on the separation insulating layer SPL. The upper gate electrode UGE may be formed on the gate insulating layer GI of the upper active region UAR. The upper gate electrode UGE may include the fourth portion PO4 between the dummy channel pattern DSP (or the seed layer SDL) and the third semiconductor pattern SP3, the fifth portion PO5 between the third semiconductor pattern SP3 and the fourth semiconductor pattern SP4, and the sixth portion PO6 on the fourth semiconductor pattern SP4.

The upper gate electrode UGE may be formed to be in contact with the second connection structure CNS2. The upper gate electrode UGE may be electrically connected to the lower gate electrode LGE through the second connection structure CNS2.

The gate capping pattern GP may be formed on the upper gate electrode UGE. The second interlayer insulating layer 120 may be additionally deposited on the gate capping pattern GP. The upper active contact UAC may be formed to penetrate (i.e., extend into) the second interlayer insulating layer 120 and may be coupled to the upper source/drain pattern USD.

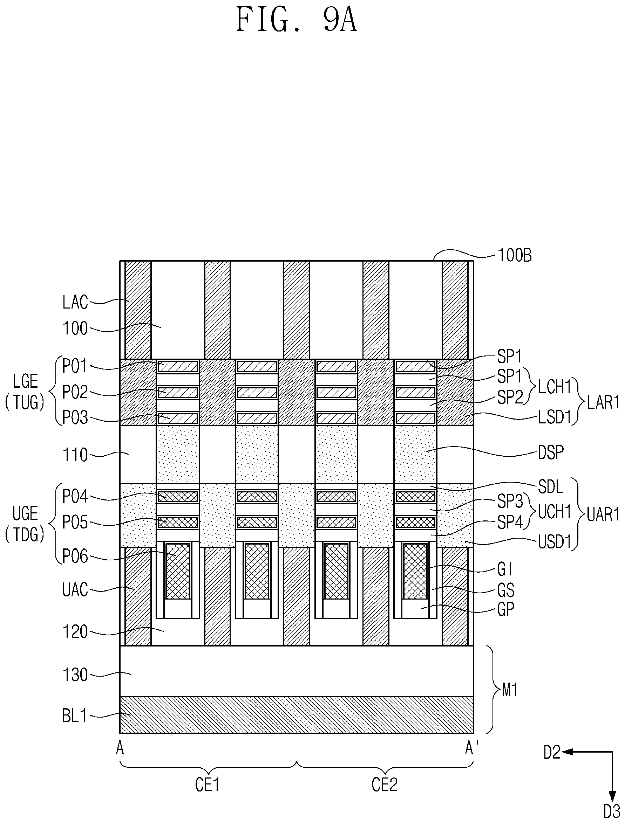

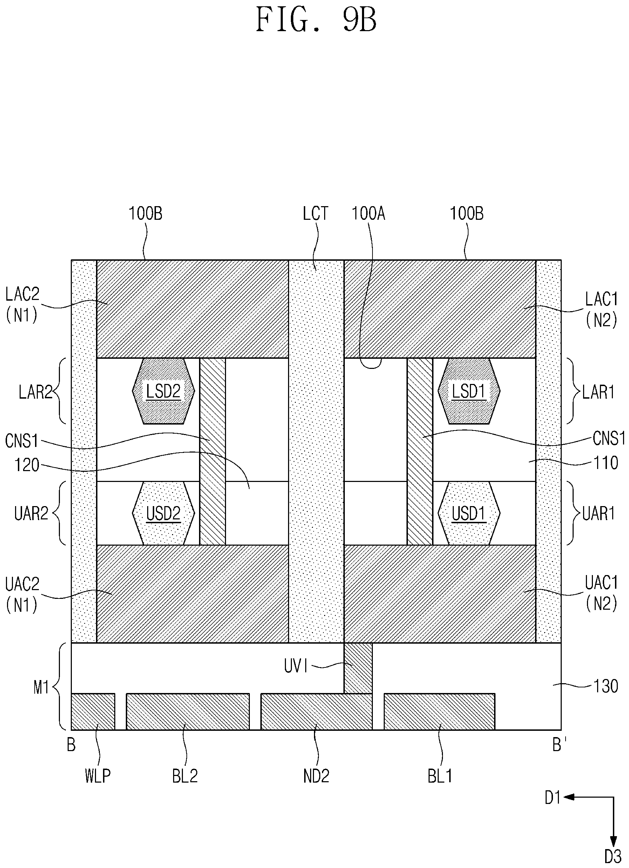

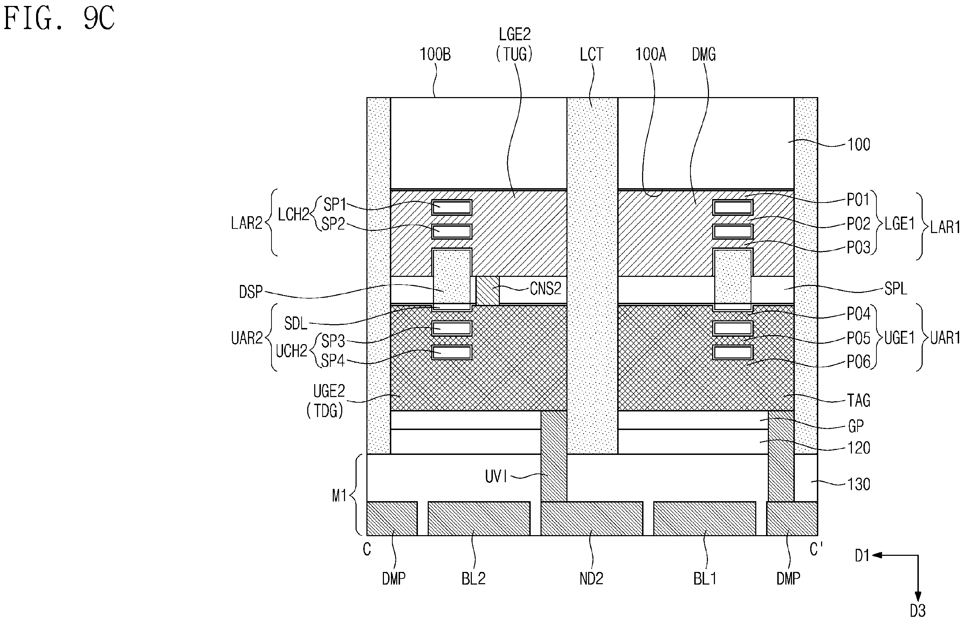

Referring to FIGS. 9A to 9C, the third interlayer insulating layer 130 may be formed on the second interlayer insulating layer 120. The first metal layer M1 may be formed in the third interlayer insulating layer 130. The upper vias UVI may be formed to electrically connect the first metal layer M1 to the upper gate electrode UGE and electrically connect the first metal layer M1 to the upper active contact UAC. The BEOL layer including the additional metal layers (e.g., M2, M3, M4, and so forth) may be formed on the first metal layer M1.

The semiconductor substrate 105 may be inverted such that a rear surface of the semiconductor substrate 105 is exposed to the outside. The exposed semiconductor substrate 105 may be selectively removed. As a result, the lower active region LAR and the device isolation layer ST may be exposed to the outside.

The substrate 100 may be formed on the exposed lower active region LAR. In an embodiment, the substrate 100 may be formed of or include at least one of silicon-based insulating materials (e.g., silicon oxide, silicon oxynitride, or silicon nitride). In an embodiment, the substrate 100 may be formed of or include the same material as the device isolation layer ST.

The first connection structure CNS1 may be formed to penetrate the substrate 100, the first interlayer insulating layer 110, and the second interlayer insulating layer 120 and may be coupled to the upper active contact UAC. In detail, the formation of the first connection structure CNS1 may include forming a penetration hole to penetrate (i.e., extend into) the substrate 100, the first interlayer insulating layer 110, and the second interlayer insulating layer 120 and expose the upper active contact UAC and filling the penetration hole with a conductive material.

The lower active contact LAC may be formed to penetrate the substrate 100 and may be coupled to the lower source/drain pattern LSD. The lower active contact LAC may be formed to be in contact with the first connection structure CNS1. The lower active contact LAC may be electrically connected to the upper active contact UAC through the first connection structure CNS1.

The cutting structure LCT may be formed to extend from the second surface 100B of the substrate 100 to the third interlayer insulating layer 130. When viewed in a plan view, the cutting structure LCT may be a line-shaped pattern, which extend in the second direction D2. The cutting structure LCT may be formed to penetrate the lower active contact LAC, the lower gate electrode LGE, the upper gate electrode UGE, and the upper active contact UAC.

The lower active contact LAC may be divided into the first and second lower active contacts LAC1 and LAC2 by the cutting structure LCT. The upper active contact UAC may be divided into the first and second upper active contacts UAC1 and UAC2 by the cutting structure LCT. The lower gate electrode LGE may be divided into the first and second lower gate electrodes LGE1 and LGE2 by the cutting structure LCT. The upper gate electrode UGE may be divided into the first and second upper gate electrodes UGE1 and UGE2 by the cutting structure LCT.

Referring back to FIGS. 3A to 3D, the lower interlayer insulating layer 210 may be formed on the second surface 100B of the substrate 100. The back-side metal layer BSM may be formed in the lower interlayer insulating layer 210. The lower vias LVI may be formed to electrically connect the back-side metal layer BSM to the lower gate electrode LGE and electrically connect the back-side metal layer BSM to the lower active contact LAC. The power delivery network layer may be formed on the back-side metal layer BSM.

Hereinafter, various embodiments of the inventive concept will be described. In the following description of these embodiments, an element previously described with reference to FIGS. 1 to 4 may be identified by the same reference number without repeating an overlapping description thereof, for concise description.

FIG. 10A is a plan view illustrating a first surface 100A of a substrate in a semiconductor memory device according to an embodiment of the inventive concept. FIG. 10B is a plan view illustrating a second surface 100B of a substrate in a semiconductor memory device according to an embodiment of the inventive concept.

FIGS. 10A and 10B illustrate one of a plurality of bit cells CE according to the present embodiment. In the embodiment of FIG. 10A, the ground lines VSS instead of the dummy pads DMP may be provided in the first metal layer M1 of the bit cell CE, when compared with the embodiment depicted in FIG. 2A or 4. The ground line VSS may be electrically connected to the upper active contact UAC through the upper via UVI. In the embodiment of FIG. 10B, the dummy pads DMP instead of the ground lines VSS may be provided in the back-side metal layer BSM of the bit cell CE, when compared with the embodiment depicted in FIG. 2A or 4. The dummy pads DMP may be in an electrically floating state.

In the present embodiment, the transistors in the lower and upper active regions LAR and UAR of the bit cell CE may be arranged to have substantially the same shape as that in the embodiment described with reference to FIG. 4.

FIG. 11A is a plan view illustrating a first surface 100A of a substrate in a semiconductor memory device according to an embodiment of the inventive concept. FIG. 11B is a plan view illustrating a second surface 100B of a substrate in a semiconductor memory device according to an embodiment of the inventive concept.

FIGS. 11A and 11B illustrates one of the bit cells CE according to the present embodiment. In the embodiment of FIG. 11A, the ground lines VSS instead of the dummy pads DMP may be provided in the first metal layer M1 of the bit cell CE, when compared with the embodiment depicted in FIG. 2A or 4. The dummy pads DMP instead of the word line pads WLP may be provided in the first metal layer M1. The ground line VSS may be electrically connected to the upper active contact UAC through the upper via UVI. The dummy pad DMP may be in an electrically floating state.

In the embodiment of FIG. 11B, the power lines VDD, the first shared pad ND1, a first word line pad WLP1, and a second word line pad WLP2 may be provided in the back-side metal layer BSM of the bit cell CE, when compared with the embodiment depicted in FIG. 2A or 4. A pair of the power lines VDD may extend in the first direction D1 and parallel to each other. The power line VDD may extend in the first direction D1, in a region located outside the bit cell CE in the second direction D2. The first word line pad WLP1, the first shared pad ND1 and the second word line pad WLP2 may be disposed between the pair of the power lines VDD. The first word line pad WLP1, the first shared pad ND1, and the second word line pad WLP2 may be sequentially arranged in the first direction D1. The first word line pad WLP1, the first shared pad ND1, and the second word line pad WLP2 may have an island shape.

The first word line pad WLP1 may be electrically connected to the gate TAG of the first pass-gate transistor TA1 through the lower via LVI. The second word line pad WLP2 may be electrically connected to the gate TAG of the second pass-gate transistor TA2 through the lower via LVI.

In the present embodiment, four PMOSFETs, which are arranged in the form of 2 X 2 array, may be provided in the lower active region LAR of the bit cell CE. In detail, the lower active region LAR may include the first pull-up transistor TU1, the second pull-up transistor TU2, the first pass-gate transistor TA1, and the second pass-gate transistor TA2. The first and second pass-gate transistors TA1 and TA2 in the present embodiment may be PMOSFETs.

In the present embodiment, four NMOSFETs, which are arranged in the form of 2 X 2 array, may be provided in the upper active region UAR of the bit cell CE. In detail, the upper active region UAR may include the first pull-down transistor TD 1, the second pull-down transistor TD2, the first dummy transistor DT1, and the second dummy transistor DT2.

According to an embodiment of the inventive concept, a node of a SRAM cell may include a first shared pad and a second shared pad, which are respectively provided on rear and front surfaces of a substrate. In other words, first and second nodes are separately disposed on the rear and front surfaces of the substrate, respectively, and thus, a cell area of the SRAM cell can be reduced. Furthermore, the SRAM cell may have a stacking structure, in which lower transistors arranged in 2 X 2 array and upper transistors arranged in 2 X 2 array are vertically stacked, and in this case, it may be possible to reduce a cell area of the SRAM cell and increase an integration density of the device.

According to an embodiment of the inventive concept, power and ground lines of the SRAM cell may be provided in a back-side interconnection layer. Accordingly, it may be possible to reduce complexity of a BEOL layer and increase a size of an interconnection line in the BEOL layer and thus, an electrical resistance in the BEOL layer can be reduced. As a result, one or more electrical characteristics of the semiconductor memory device may be improved.

While example embodiments of the inventive concept have been particularly shown and described, it will be understood by one of ordinary skill in the art that variations in form and detail may be made therein without departing from the scope of the attached claims.

## Claims

1. A semiconductor memory device, comprising:
a substrate including a first surface and a second surface, the first and second surfaces of the substrate being opposite to each other;
a lower active region on the first surface, the lower active region comprising a lower gate electrode and a lower active contact which are spaced apart from each other in a first direction perpendicular to the first surface;
an upper active region stacked on the lower active region in the first direction, the upper active region comprising an upper gate electrode and an upper active contact, which are spaced apart from each other in the first direction;
a first metal layer on the first surface; and
a back-side metal layer on the second surface,
wherein the back-side metal layer comprises a first shared pad electrically connecting the lower gate electrode to the lower active contact, and
the first metal layer comprises a second shared pad electrically connecting the upper gate electrode to the upper active contact.

2. The semiconductor memory device of claim 1, wherein the first shared pad and the second shared pad are vertically overlapped with each other.

3. The semiconductor memory device of claim 2, wherein an area of the first shared pad, in a plan view, is different from an area of the second shared pad.

4. The semiconductor memory device of any preceding claim, wherein:
the first shared pad is configured as an output terminal of a first inverter of a static random-access memory, SRAM, cell, and
the second shared pad is configured as an output terminal of a second inverter of the SRAM cell.

5. The semiconductor memory device of any preceding claim, wherein the back-side metal layer further comprises a power line.

6. The semiconductor memory device of any preceding claim, wherein the first metal layer further comprises a bit line.

7. The semiconductor memory device of any preceding claim, further comprising a cutting structure between the lower gate electrode and the lower active contact, and between the upper gate electrode and the upper active contact,
wherein the cutting structure is a line-shaped pattern, which extends in a direction parallel to an upper surface of the substrate, when viewed in a plan view.

8. The semiconductor memory device of claim 7, wherein the cutting structure extends into the lower active region and the upper active region.

9. The semiconductor memory device of any preceding claim, wherein the lower active region comprises a first semiconductor pattern and a second semiconductor pattern on the first semiconductor pattern,
the lower gate electrode extends around the first and second semiconductor patterns,
the upper active region comprises a third semiconductor pattern and a fourth semiconductor pattern on the third semiconductor pattern, and
the upper gate electrode extends around the third and fourth semiconductor patterns.

10. The semiconductor memory device of any preceding claim, wherein the lower active region comprises a first pull-up transistor and a second pull-up transistor,
the upper active region comprises a first pull-down transistor and a second pull-down transistor,
the first pull-down transistor is stacked on the first pull-up transistor in the first direction, and
the second pull-down transistor is stacked on the second pull-up transistor in the first direction.
